# FASCICULE DE BREVET EUROPEEN

(11) **EP 0 349 044 B1**
(45) Date de publication et mention de la délivrance du brevet: **08.09.1993**
(21) Numéro de dépôt: 89201602.3
(22) Date de dépôt: 19.06.1989
(51) Int. Cl.: C23C 28/00, C23C 16/02, C23C 16/20, C23C 16/40

(54) **Procédé de réalisation d'un film protecteur sur un substrat à base de magnésium, applicaton à la protection des alliages de magnésium, substrats obtenus**
Verfahren zur Herstellung eines Schutzfilmes auf einem Substrat auf Magnesiumbasis, Anwendung zum Schutz von Magnesiumlegierungen, dabei erhaltene Substrate
Process for the production of a protective film on a magnesium-based substrate, application to the protection of magnesium alloys, substrates thus obtained

(30) Priorité: 01.07.1988 FR 8809050
(43) Date de publication de la demande: 03.01.1990
(73) Titulaire: CENTRE DE RECHERCHE ET DE PROMOTION DU MAGNESIUM C E P R O M A G, 12300 Decazeville (FR)
(72) Inventeur: Dabosi, Francis, Jean, Paul, F-31520 Ramonville Saint Agne (FR); Morancho, Roland, F-31200 Toulouse (FR); Pouteau, Dominique, F-31000 Toulouse (FR)
(74) Mandataire: Barre, Philippe

(56) Documents cités:
- EP-A- 0 022 349
- FR-A- 1 570 828
- FR-A- 2 078 033
- FR-A- 2 589 485
- US-A- 2 671 739
- US-A- 2 867 546
- US-A- 2 880 115
- US-A- 2 921 868
- US-A- 4 504 522

## Description

L'invention concerne un procédé de réalisation d'un film protecteur sur un substrat métallique à base de magnésium. Elle vise en particulier les applications dudit procédé pour protéger les alliages de magnésium les plus couramment utilisés dans l'industrie.

Le magnésium est un métal possédant des propriétés très spécifiques, qui est utilisé dans un nombre croissant d'applications (en général sous forme d'alliage, notamment GA9, GA9Z₁, MSR et RZ5) : rapport favorable densité/propriétés mécaniques, facilité d'usinage, propriété d'amortissement des vibrations, caractéristiques de fluage à température moyenne.

Toutefois, le magnésium est le métal le plus actif sur le plan électrochimique (potentiel standard d'électrode de -2,3 volts par rapport à l'électrode normale à hydrogène à l'ambiante) et est donc extrêmement sensible à la corrosion.

Les techniques actuellement utilisées pour revêtir un substrat à base de magnésium d'une couche protectrice sont essentiellement les suivantes : anodisation en bain fluoré suivie d'une chromatation, mordangage chimique suivi d'une imprégnation de polymères, électrodéposition de peintures ou vernis. Ces protections sont efficaces en conditions statiques, c'est-à-dire en l'absence de sollicitation du substrat en surface ; par contre, en conditions dynamiques (frottements, usures dynamiques...), ces protections se rayent ou sont abrasées et laissent très rapidement apparaître le substrat. De plus les traitements de chromatation connus utilisent des bains toxiques qui conduisent à des problèmes de pollution mal résolus à l'heure actuelle.

Par ailleurs, il existe une technique de métallisation de substrats en magnésium par dépôt électrolytique d'aluminium. Toutefois, cette technique conduit à une couche peu compacte d'aluminium qui rend la surface du substrat moins active mais qui constitue une protection très peu efficace ; en outre, ladite couche est peu adhérente et donc comme les protections déjà évoquées est peu efficace en conditions dynamiques.

En outre, le brevet japonais A-61.190.078 propose un procédé de protection du magnésium consistant à effectuer une métallisation sous vide d'aluminium sur le substrat, puis à procéder à un traitement au moyen d'un bain de chromatation ; de façon analogue, le brevet FR 2.589.485 décrit un procédé de traitement du magnésium, consistant à effectuer un placage ionique d'aluminium, suivi d'un traitement de chromatation dans un bain. Toutefois dans ces documents, le traitement de chromatation n'est pas explicité, de sorte qu'il n'est pas possible de connaître les performances des revêtements obtenus notamment en conditions dynamiques. De plus, ces procédés de protection, mettant en oeuvre des bains de sels de chrome, sont soumis aux inconvénients de toxicité et de pollution déjà évoqués.

Enfin, il convient de noter le brevet US 2.880.115 qui décrit le dépôt en phase vapeur d'une couche de protection en aluminium ou magnésium sur divers types de substrats tels que acier, fer, cuivre, magnésium et aluminium.

La présente invention se propose de fournir une solution satisfaisante au problème technique sus-évoqué de protection d'un substrat à base de magnésium.

Un objectif essentiel de l'invention est de réaliser sur ledit substrat un film protecteur parfaitement inerte sur le plan électrochimique de façon à éliminer tout risque de corrosion.

Un autre objectif est de réaliser un film protecteur de grande dureté superficielle, adhérant très fortement sur le substrat de façon à constituer une protection efficace, non seulement en conditions statiques mais également en conditions dynamiques (usure, frottements, chocs...).

Un autre objectif est de permettre de protéger des substrats présentant des surfaces complexes par un film protecteur continu.

Un autre objectif est de permettre d'ajuster facilement l'épaisseur du film protecteur en fonction de l'application.

Un autre objectif est d'éviter l'utilisation de bains toxiques conduisant à des problèmes de pollution.

A cet effet, le procédé conforme à l'invention pour réaliser un film protecteur sur un substrat métallique à base de magnésium consiste à déposer successivement par dépôt chimique en phase vapeur au moins deux couches, l'une dite couche intermédiaire à base d'aluminium métallique, l'autre superposée à la première, à base d'un oxyde métallique choisi parmi le groupe suivant : oxyde de titane, alumine, oxyde de zirconium, oxyde de chrome, oxyde de silicium, lesdits dépôts étant effectués en choisissant un précurseur de l'aluminium et un précurseur de l'oxyde métallique aptes à se décomposer à des températures inférieures à 430° C, en portant le substrat à la température de décomposition du précurseur de l'aluminium, en amenant en phase vapeur ledit précurseur au contact dudit substrat, puis, après dépôt de la couche intermédiaire, en portant le substrat à la température de décomposition du précurseur de l'oxyde métallique et en amenant en phase vapeur ledit précurseur au contact dudit substrat.

Les expérimentations ont montré qu'un tel procédé conduit à un film protecteur extrêmement efficace à l'égard de la corrosion et bénéficiant d'une cohésion remarquable entre couches et d'un excellent accrochage du film sur le substrat. En particulier un tel film résiste de façon tout à fait satisfaisante à des conditions de sollicitation dynamiques sans arrachement ni détérioration. Cette remarquable cohésion et liaison du film sur le substrat semble provenir du processus de dépôts successifs par CVD des couches : cette technique crée au voisinage de la surface du substrat des espèces naissantes des composés et le dépôt de ces espèces à l'état natif s'accompagne d'une diffusion superficielle, d'une part, à l'interface substrat/couche intermédiaire d'aluminium, des métaux en présence (magnésium, aluminium), d'autre part, à l'interface des deux couches du film, de l'aluminium et de l'oxyde en présence. La fonction de la couche intermédiaire est ainsi de servir de couche d'accrochage de la couche d'oxyde. Réalisée en un métal ayant un coefficient de dilatation identique de celui du magnésium, elle évite en cas de contraintes thermiques qu'apparaisse un décollement du film protecteur. La couche d'oxyde est dur et inerte sur le plan électrochimique, de sorte qu'elle constitue une excellente protection.

Il est à noter que les dépôts CVD peuvent, le cas échéant, être assisté par plasma selon un processus en soi connu. Cette assistance plasma est en particulier utilisée dans le cas où la couche d'oxyde est de l'oxyde de silicium, le précurseur choisi étant alors du tétraéthoxysilane qui se décompose à 100° C environ en CVD assisté par plasma.

Le cas échéant, plusieurs couches métalliques intermédiaires et/ou plusieurs couches d'oxydes métalliques peuvent être prévues en vue d'assurer une relaxation optimum des contraintes entre couches.

Selon un mode de mise en oeuvre intéressant, on forme une couche d'oxyde constituée par de l'oxyde de titane qui possède un précurseur (tétraisopropylorthotitanate : TIPOT) dont la décomposition s'observe à partir de 360° C, permettant une croissance rapide du dépôt.

La couche intermédiaire en aluminium métallique est avantageusement obtenue par CVD dans les conditions suivantes : l'on choisit un précurseur constitué par le triisobutylaluminium (TIBA), l'on porte ledit précurseur à une température comprise entre environ 10° C et 60° C pour en amener une fraction en phase vapeur, l'on porte le substrat à une température comprise entre environ 250° C et 350° C et l'on amène la vapeur de TIBA au contact dudit substrat.

De préférence, ce dépôt d'aluminium est effectué sous vide primaire à une pression inférieure à 10 Pascals. L'on augmente ainsi la diffusion de l'espèce gazeuse et l'on obtient une meilleure uniformité du dépôt quelle que soit la complexité de la surface du substrat.

De plus, la durée du dépôt sera en pratique adaptée pour engendrer une couche d'aluminium d'épaisseur comprise entre 0,1 et 2 microns. Cette épaisseur est bien adaptée pour obtenir une couche d'accrochage de bonne efficacité.

Dans le cas préférentiel où la couche d'oxyde est en oxyde de titane, celle-ci est avantageusement obtenue par CVD dans les conditions suivantes : l'on choisit un précurseur constitué par le tétraisopropylorthotitanate (TIPOT), l'on chauffe ledit précurseur à une température comprise entre environ 30° C et 60° C pour en amener une fraction en phase vapeur, l'on porte le substrat à une température comprise entre environ 360° C et 430° C, et l'on amène la vapeur de TIPOT au contact dudit substrat.

De façon connue en soi dans les techniques CVD, la vapeur de TIBA de même que la vapeur de TIPOT peuvent être transportées vers le substrat au moyen d'un gaz vecteur inerte vis à vis de ladite vapeur, à une pression réduite comprise notamment entre environ 50 et 500 Pascals, qui assure une bonne diffusion des espèces gazeuses quelle que soit la complexité du substrat. Pour la vapeur de TIBA, on peut utiliser de l'hélium haute pureté, ou de l'azote haute pureté ; pour la vapeur de TIPOT, on peut utiliser ces deux gaz et de l'oxygène en gaz de dilution qui conduit à une meilleure stoechiométrie du dépôt. La durée du dépôt sera en pratique adaptée pour engendrer une couche d'oxyde de titane d'épaisseur comprise entre 1 et 5 microns. Le choix de l'épaisseur dans cette plage est choisi en fonction des contraintes mécaniques auxquelles doit être soumis le substrat.

Après formation de la couche d'oxyde de titane, le substrat est refroidi, de préférence lentement pour éviter un choc thermique (vitesse de refroidissement inférieure environ à 3°/min.).

Dans le cas d'une couche externe constituée d'alumine, le précurseur choisi peut être le triisopropoxyde d'aluminium qui se décompose entre 380° C et 420° C en CVD classique. Dans le cas de l'oxyde de zirconium, le précurseur choisi peut être le tétrapentadionate de zirconium qui se décompose entre 300° C et 430° C en CVD classique. Dans le cas de l'oxyde de chrome, le précurseur choisi peut être soit le chromecarbonyle qui se décompose entre 260° C et 320° C en CVD classique, soit le dibenzènechrome qui se décompose entre 350° C et 400° C.

Dans ce dernier cas d'une couche de surface à base d'oxyde de chrome, le procédé de l'invention est de préférence mis en oeuvre selon le mode ci-après décrit qui accroît notablement la dureté du revêtement obtenu : le précurseur choisi est le chromehexacarbonyle (qui est porté entre environ 10° C et 40° C pour en amener une fraction en phase vapeur) et la vapeur de ce pré curseur est transportée par un gaz vecteur constitué par de l'hélium qui, après passage sur le précurseur, est dilué avec de l'oxygène, le substrat étant porté entre 260° C et 320° C. On obtient ainsi une couche d'oxyde qui comporte en profondeur du carbure de chrome augmentant la dureté.

Le procédé de l'invention est applicable pour réaliser un film protecteur sur tout substrat à base de magnésium et en particulier sur les alliages de magnésium les plus couramment utilisés : GA9 (Mg, 9 % Al), GA9Z1 (Mg, 9 % Al, 1% Zn), MSR (Mg, 2 % terres rares, 2 % Ag, 0,5 % Zr), RZ5 (Mg, 4 % Zn, 1 % terres rares, 0,5 % Zr).

Pour réduire la porosité microscopique du revêtement, il est possible d'immerger le substrat revêtu dans un bain aqueux bouillant pendant au moins 30 minutes ; on obtient ainsi un effet de colmatage en surface.

La description qui suit en référence aux figures des dessins annexés illustre des exemples de mise en oeuvre du procédé de l'invention ; sur ces dessins :

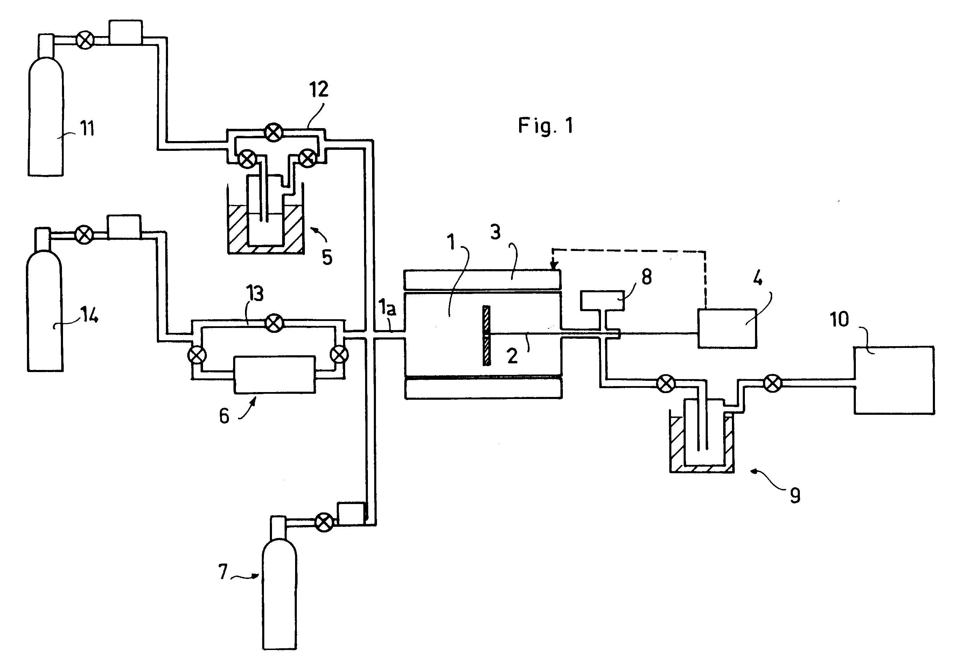

- la figure 1 est un schéma de l'installation de CVD utilisée pour la mise en oeuvre des exemples,
- les figures 2 et 3 sont des diagrammes comparatifs fournissant des courbes illustrant le comportement électrochimique de substrats revêtus et non revêtus.

Les exemples ci-après visent à protéger un substrat constitué par une plaquette circulaire en GA9Z₁ de 2 mm d'épaisseur. Ce substrat est préalablement poli, rincé aux ultrasons dans de l'alcool puis rincé à l'acétone et séché à l'air comprimé sec, afin d'obtenir un état de surface propre et parfaitement dégraissé.

Le substrat ainsi préparé est disposé dans un réacteur 1 de CVD. En l'exemple, il est accroché en position verticale à une sonde de thermocouple 2. De façon classique, le réacteur est associé à des résistances de chauffage 3 thermostatées, commandées par un régulateur de température 4 recevant les informations de température de la sonde 2.

L'entrée la du réacteur est reliée par des conduits, d'une part, à un saturateur 5 de TIBA (triisobutylaluminium), d'autre part à un générateur 6 de précurseur d'oxyde métallique, enfin à une bouteille 7 de gaz de dilution (oxygène).

Le saturateur 5 et le générateur 6 reçoivent respectivement en entrée un débit soit d'azote haute pureté provenant d'une bouteille 11, soit d'hélium provenant d'une bouteille 14. Des vannes et débitmètres massiques permettent d'ajuster le débit du composé envoyé vers le réacteur ou d'assurer un balayage par le gaz choisi à travers des dérivations 12 ou 13.

Le sortie du réacteur 2 est reliée à une jauge de pression 8 et à un piège à azote liquide 9.

Un système de pompage dynamique 10 permet d'ajuster la pression dans le réacteur 1.

Dans une phase préalable, les conduits sont purgés par un pompage durant 1 heure environ, qui assure un vide primaire de 5 pascals environ.

L'azote est ensuite délivré par la dérivation 12 afin de remplir le réacteur et l'ensemble des conduits, à une pression d'environ 130 pascals. Le réacteur est chauffé à 280° C.

Une fois cette température atteinte, on met en ligne le saturateur 5 afin d'envoyer dans le réacteur 1 les vapeurs de TIBA. Ce saturateur 5 contient du TIBA liquide et est chauffé au bain-marie à 45° C. Il est à noter que le conduit reliant le saturateur 5 et le réacteur 1 est équipé d'un cordon chauffant porté à 60° C afin d'éviter les recondensations de TIBA. La température du réacteur 1 et donc celle du substrat est régulée à 280° C. Cette opération de dépôt d'aluminium dure 30 minutes.

A l'issue de celle-ci, le saturateur 5 est mis hors circuit, l'azote est à nouveau délivré par la dérivation 12 avec une pression dans le réacteur d'environ 130 pascals, en vue de déposer la couche d'oxyde métallique dans les conditions fournies ci-après.

### Exemple 1 : Couche d'oxyde métallique constituée par de l'oxyde de titane

Le réacteur est chauffé à une température plus élevée de 380° C. Une fois la température stabilisée, on met l'azote hors circuit et on met en ligne le générateur 6 qui est constitué en cet exemple par un saturateur contenant du TIPOT liquide (tétraisopropylorthotitanate) chauffé au bain-marie à 30° C. La bouteille d'hélium 14 et la bouteille d'oxygène 7 sont également mises en ligne pour fournir de l'hélium comme gaz vecteur et de l'oxygène comme gaz de dilution de façon que la pression dans le réacteur 1 soit égale à 130 pascals. Cette opération de dépôt d'oxyde de titane dure deux heures.

A l'issue de celle-ci, le générateur 6 est mis hors circuit, l'hélium continuant à circuler par la dérivation 13. Le chauffage du réacteur est coupé de façon à engendrer un lent refroidissement de celui-ci. On coupe également le système de pompage 10 afin de revenir lentement à la pression atmosphérique. Au bout de deux heures environ, le réacteur est à la température ambiante, on ferme la bouteille d'hélium 14 et celle d'oxygène 7 et le substrat peut être retiré.

Les analyses suivantes sont effectuées sur celui-ci : analyse au microscope électronique à balayage couplé à un analyseur en dispersion d'énergie X pour identifier les éléments lourds présents en surface, analyse aux rayons X pour caractériser le composé présent en surface, coupe transversale avec mesure d'épaisseur au microscope électronique, analyse par spectroscopie d'électrons "AUGER" du profil de concentration, analyse par E.S.C.A., mesure de dureté VICKERS, mesure du comportement électrochimique par détermination des courbes intensité/potentiel en milieu Na₂SO₄ 0,5 M et test qualitatif d'adhérence au "Scotch".

Ces analyses et tests ont fourni les résultats suivants.

L'épaisseur totale de revêtement est de 4 microns (1,5 micron d'Al et 2,5 microns d'oxyde de titane).

La couche de surface est constituée de TiO₂ sous forme d'anatase.

Le test d'adhérence consiste à rayer la couche selon un quadrillage, à coller un morceau de "Scotch" adhésif sur celle-ci et à arracher ce "Scotch". On n'observe aucun décollement de matière, ce qui démontre une bonne adhérence tant de la couche intermédiaire d'aluminium sur le substrat, que de la couche d'oxyde de titane sur ladite couche intermédiaire d'aluminium. Le profil de concentration obtenu par spectroscopie AUGER est caractéristique d'une diffusion des éléments aux interfaces.

La dureté initiale (VICKERS) de l'alliage de magnésium était de 70 kg/mm² ; cette dureté devient après revêtement égale à 280 kg/mm².

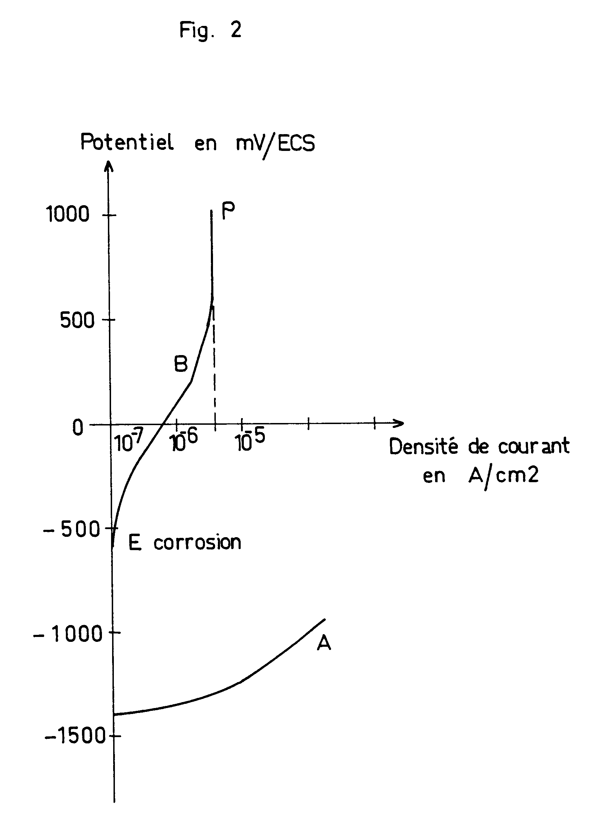

La figure 2 fournit la courbe intensité/potentiel en milieu Na₂SO₄ de l'alliage de magnésium non revêtu (courbe A) et celle de l'alliage protégé par le revêtement (courbe B).

En abscisse sont portées les densités de courant en A/cm² et en ordonnée les potentiels en millivolts par rapport à l'électrode au calomel saturé.

On constate que le revêtement conduit à une très forte augmentation du potentiel de corrosion, avec l'apparition d'un palier de passivité P pour une densité de 6.10⁻⁶ A/cm² environ. Des expérimentations répétées démontrent la parfaite reproductibilité de ces résultats.

### Exemple 2 : Couche d'oxyde métallique constituée par de l'alumine

Les conditions de mise en oeuvre sont analogues avec les particularités suivantes :
. réacteur chauffé à 400° C,
. générateur 6 constitué par une nacelle contenant du triisopropoxyde d'aluminium solide chauffé par bain d'huile à 120° C,
. couche de surface obtenue, constituée de Al₂O₃,
. épaisseur totale du revêtement obtenu : 2,5 microns (1,5 microns d'Al et 1 micron d'alumine),
. test d'adhérence : résultat identique au précédent.

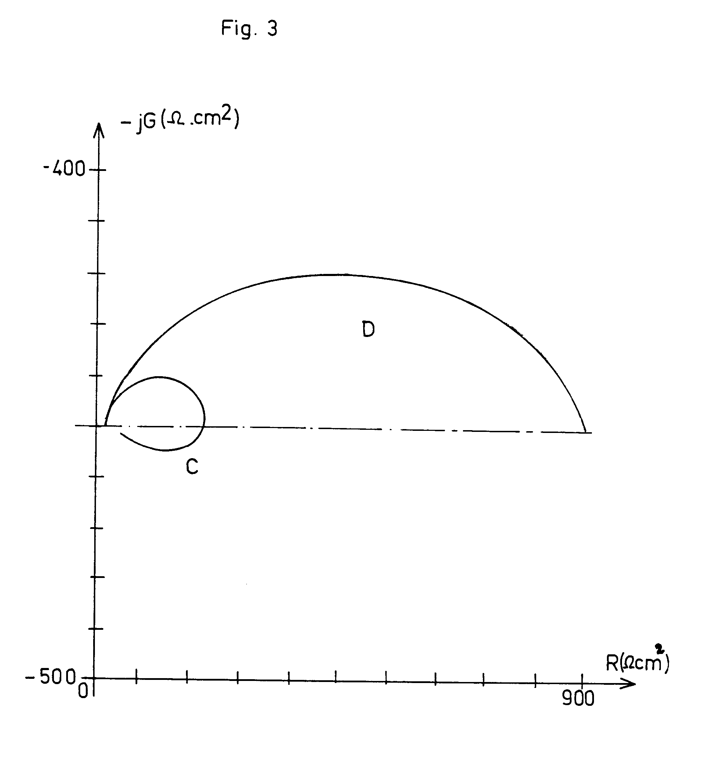

La figure 3 fournit le diagramme d'impédance électro-chimique en coordonnées de Nyquist en milieu Na₂SO₄ de l'alliage de magnésium non revêtu (courbe C) et celle de l'alliage protégé par le revêtement (courbe D).

On constate que le revêtement conduit à une disparition de la boucle inductive correspondant au phénomène de corrosion du magnésium et à un élargissement de la boucle capacitive traduisant l'amélioration de la résistance à la corrosion.

### Exemple 3 : Couche d'oxyde métallique constituée par de l'oxyde de chrome

Les conditions de mise en oeuvre sont analogues avec les particularités suivantes :
. réacteur chauffé à 300° C,
. générateur 6 constitué par une nacelle contenant du chromehexacarbonyle solide, à température ambiante de 20° C,
. durée du dépôt : 1 heure,
. couche de surface obtenue, constituée de Cr₂O₃ majoritaire et de CrO₃,
. épaisseur totale du revêtement obtenu : 5 microns (1,5 microns d'Al et 3,5 microns d'oxyde de chrome).
. dureté Vickers : 800 kg/mm²,
. test d'adhérence : résultat identique aux précédents.

L'analyse E.S.C.A. a révélé en surface de la couche la présence de Cr₂O₃ et de CrO₃ ; l'analyse par rayon X révèle la présence de carbure de chrome en profondeur.

Le diagramme d'impédance électro-chimique en coordonnées de Nyquist en milieu Na₂SO₄ de l'alliage de magnésium protégé par le revêtement est le même que celui obtenu à l'exemple précédent (figure 3, courbe D).

Comme précédemment, le revêtement conduit à une disparition de la boucle inductive correspondant au phénomène de corrosion du magnésium.

La valeur élevée de la dureté Vickers provient de la présence du carbure de chrome dans la couche de surface. Il est à noter que, de façon inattendue, cette présence ne réduit pas l'adhérence de cette couche sur la couche intermédiaire d'aluminium.

### Exemple 4

Le substrat revêtu à l'exemple 1 est immergé dans un bain d'eau bouillante pendant 1 heure environ. On constate que le potentiel de corrosion est décalé vers le haut d'une valeur de l'ordre et 200 mV/ECS.

## Revendications

1. Procédé de réalisation d'un film protecteur sur un substrat métallique à base de magnésium, dans lequel on dépose successivement par dépôt chimique en phase vapeur au moins deux couches, l'une dite couche intermédiaire à base d'aluminium métallique, l'autre superposée à la première, à base d'un oxyde métallique choisi parmi le groupe suivant : oxyde de titane, alumine, oxyde de zirconium, oxyde de chrome, oxyde de silicium, lesdits dépôts étant effectués en choisissant un précurseur de l'aluminium et un précurseur de l'oxyde métallique aptes à se décomposer à des températures inférieures à 430° C, en portant le substrat à la température de décomposition du précurseur de l'aluminium, en amenant en phase vapeur ledit précurseur au contact dudit substrat, puis, après dépôt de la couche d'aluminium, en portant le substrat à la température de décomposition du précurseur de l'oxyde métallique et en amenant en phase vapeur ledit précurseur au contact dudit substrat.

2. Procédé selon la revendication 1, dans lequel l'on transporte les vapeurs des précurseurs vers le substrat, au moyen d'un gaz vecteur inerte vis à vis desdites vapeurs, à pression réduite.

3. Procédé selon l'une des revendications 1 ou 2, caractérisé en ce que, pour réaliser la couche intermédiaire, l'on choisit un précurseur constitué par le triisobutylaluminium (TIBA), l'on porte ledit précurseur à une température comprise entre environ 10° C et 60° C pour en amener une fraction en phase vapeur l'on porte le substrat à une température comprise entre environ 250° C et 350° C et l'on amène la vapeur de TIBA au contact dudit substrat.

4. Procédé selon la revendication 3, dans lequel le dépôt en phase vapeur d'aluminium est effectué sous vide primaire, à une pression inférieure à 10 pascals.

5. Procédé selon l'une des revendications 3 ou 4, dans lequel l'on amène la vapeur de TIBA au contact du substrat pendant une durée adaptée pour engendrer un dépôt d'aluminium d'épaisseur comprise entre 0,1 et 2 microns.

6. Procédé selon la revendication 2, caractérisé en ce que pour réaliser une couche d'oxyde métallique constituée par de l'oxyde de titane, l'on choisit un précurseur constitué par le tétraisopropylorthotitanate (TIPOT), l'on chauffe ledit précurseur à une température comprise entre environ 30° C et 60° C pour en amener une fraction en phase vapeur, l'on porte le substrat à une température comprise entre environ 360° C et 430° C, et l'on amène la vapeur de TIPOT au contact dudit substrat.

7. Procédé selon la revendication 6, dans lequel l'on amène la vapeur de TIPOT au contact du substrat pendant une durée adaptée pour engendrer un dépôt d'oxyde de titane d'épaisseur comprise entre 1 et 5 microns.

8. Procédé selon les revendications 3 et 6 prises ensemble, caractérisé en ce que, après formation de la couche d'oxyde de titrane, l'on refroidit lentement le substrat.

9. Procédé selon la revendication 2, caractérisé en ce que, pour réaliser une couche de surface à base d'oxyde de chrome contenant du carbure de chrome l'on choisit un précurseur constitué par le chromehexacarbonyle, l'on porte ledit précurseur à une température comprise entre environ 10° C et 40° C pour en amener une fraction en phase vapeur l'on transporte la vapeur obtenue au moyen d'un gaz vecteur constitué par de l'oxygène l'on porte le substrat à une température comprise entre 260° C et 320° C et l'on amène le gaz vecteur et la vapeur au contact dudit substrat.

10. Application du procédé conforme à l'une des revendications 1 à 9 pour réaliser un film protecteur sur un substrat en un alliage de magnésium du groupe suivant : GA9 (Mg, 9 % Al), GA9Z1 (Mg, 9 % Al, 1% Zn), MSR (Mg, 2 % terres rares, 2 % Ag, 0,5 % Zr), RZ5 (Mg, 4 % Zn, 1 % terres rares, 0,5 % Zr).

11. Application selon la revendication 10, dans laquelle on soumet le substrat revêtu à un traitement de colmatage dans une solution aqueuse bouillante.

## Claims

1. Process for the production of a protective film on a magnesium-based metallic substrate, whereby at least two layers are successively deposited by chemical vapour-phase deposition, i.e. a so-called intermediate layer on a metallic aluminium base and a second layer which is superimposed on the first layer and based on a metallic oxide chosen from the following group: titanium oxide, alumina, zirconium oxide, chromium oxide and silicon oxide, said depositions being brought about by selecting a precursor of the aluminium and a precursor of the metallic oxide capable of decomposing at temperatures below 430°C, by imparting to the substrate the temperature at which the precursor of the aluminium decomposes, by bringing said precursor in the vapour phase in contact with said substrate, then by imparting to the substrate, after deposition of the aluminium layer, the temperature at which the precursor of the metallic oxide decomposes and by bringing said precursor in the vapour phase into contact with said substrate.

2. Process according to Claim 1, in which the vapours of the precursors are conveyed to the substrate by means of a carrier gas inert in respect of said vapours, at reduced pressure.

3. Process according to one of Claims 1 or 2, characterised in that, in order to produce the intermediate layer, a precursor constituted by triisobutylaluminium (TIBA) is chosen, said precursor is imparted a temperature between about 10°C and 60°C so as to vaporise a fraction thereof, the substrate is imparted a temperature between about 250°C and 350°C and the TIBA vapour is brought into contact with said substrate.

4. Process according to Claim 3, in which the deposition of aluminium in the vapour phase is brought about subject to primary vacuum at a pressure below 10 Pascal.

5. Process according to one of Claims 3 or 4, in which the TIBA vapour is brought into contact with the substrate for such a time as to bring about an aluminium deposit with a thickness between 0.1 and 2 microns.

6. Process according to Claim 2, characterised in that for producing a layer of metallic oxide constituted by titanium oxide, a precursor constituted by tetraisopropylorthotitanate (TIPOT) is chosen, said precursor is heated to a temperature between about 30°C and 60°C in order to vaporise a fraction thereof, the substrate is imparted a temperature between about 360°C and 430°C and the TIPOT vapour is brought into contact with said substrate.

7. Process according to Claim 6, in which the TIPOT vapour is brought into contact with the substrate for a time appropriate to bring about a deposit of titanium oxide with a thickness between 1 and 5 microns.

8. Process according to Claims 3 and 6 jointly, characterised in that, after forming the titanium oxide layer, the substrate is cooled slowly.

9. Process according to Claim 2, characterised in that for the production of a surface layer based on chromium oxide containing chromium carbide, a precursor constituted by chromium hexacarbonyl is chosen, said precursor is imparted a temperature between about 10°C and 40°C in order to vaporise a fraction thereof, the vapour produced is conveyed by means of a carrier gas constituted by oxygen, the substrate is imparted a temperature between 260°C and 320°C and the carrier gas and the vapour are brought into contact with said substrate.

10. Application of the process according to one of Claims 1 to 9 in order to produce a protective film on a substrate consisting of a magnesium alloy pertaining to the following group: GA9 (Mg, 9% Al), GA9Z1 (Mg, 9% Al, 1% Zn), MSR (Mg, 2% rare earths, 2% Ag, 0.5% Zr), RZ5 (Mg, 4% Zn, 1% rare earths, 0.5% Zr).

11. Application according to Claim 10, in which the coated substrate is subjected to a sealing treatment in a boiling aqueous solution.

## Patentansprüche

1. Verfahren zur Herstellung eines Schutzfilmes auf einem metallischen Substrat auf Magnsiumbasis, bei dem man durch chemische Absetzung in Dampfphase nacheinander mindestens zwei Schichten aufträgt, und zwar eine sogenannte Zwischenschicht auf metallischer Aluminiumbasis und eine der ersten Schicht überlagerte zweite Schicht, die auf einem der folgenden Gruppe - Titanoxid, Tonerde, Zirconoxid, Chromoxid, Siliziumoxid - angehörenden Metalloxid basiert, wobei die besagten Absetzungen dadurch bewirkt werden, daß man einen Vorläufer des Aluminiums und einen Vorläufer des Metalloxids wählt, die so beschaffen sind, daß sie sich bei Temperaturen von weniger als 430°C zersetzen, daß man das Substrat auf die Zersetzungstemperatur des Aluminiumvorläufers bringt, daß man den besagten Vorläufer in der Dampfphase mit dem besagten Substrat in Kontakt bringt, daß man dann nach Absetzung der Aluminiumschicht das Substrat auf die Zersetzungstemperatur des Vorläufers des Metalloxids bringt und daß man den besagten Vorläufer mit dem besagten Substrat in Kontakt bringt.

2. Verfahren nach Anspruch 1, bei dem man die Dämpfe der Vorläufer mit Hilfe eines den besagten Dämpfen gegenüber trägen Gases bei verringertem Druck dem Substrat zuführt.

3. Verfahren nach einem der Ansprüche 1 oder 2, dadurch gekennzeichnet, daß man zwecks Herstellung der Zwischenschicht einen in Triisobutylaluminium (TIBA) bestehenden Vorläufer wählt, den besagten Vorläufer auf eine Temperatur zwischen etwa 10°C und 60°C bringt, um einen Teil davon in die Dampfphase zu bringen, das Substrat auf eine Temperatur zwischen etwa 250°C und 350°C bringt und den Dampf des TIBA mit dem besagten Substrat in Kontakt bringt.

4. Verfahren nach Anspruch 3, bei dem die Absetzung des Aluminiums in der Dampfphase unter Primärvakuum bei einem Druck von weniger als 10 Pascal bewirkt wird.

5. Verfahren nach einem der Ansprüche 3 oder 4, bei dem der Dampf des TIBA während einer Zeitspanne mit dem Substrat in Kontakt gebracht wird, die so beschaffen ist, daß eine Aluminiumbeschichtung mit einer Dicke zwischen 0,1 und 2 Mikron entsteht.

6. Verfahren nach Anspruch 2, dadurch gekennzeichnet, daß man zwecks Herstellung einer in Titanoxid bestehenden Metalloxidschicht einen in Tetraisopropylorthotitanat (TIPOT) bestehenden Vorläufer wählt, den besagten Vorläufer auf eine Temperatur zwischen etwa 30°C und 60°C erwärmt, um einen Teil davon in Dampfphase zu bringen, das Substrat auf eine Temperatur zwischen etwa 360°C und 430°C bringt und den Dampf des TIPOT mit dem besagten Substrat in Kontakt bringt.

7. Verfahren nach Anspruch 6, bei dem man den Dampf des TIPOT mit dem Substrat während einer Zeitspanne in Kontakt bringt, die so beschaffen ist, daß eine Titanoxidbeschichtung mit einer Dicke zwischen 1 und 5 Mikron entsteht.

8. Verfahren nach den Ansprüchen 3 und 6 gemeinsam, dadurch gekennzeichnet, daß das Substrat nach Bildung der Titanoxidschicht langsam gekühlt wird.

9. Verfahren nach Anspruch 2, dadurch gekennzeichnet, daß man zwecks Herstellung einer Oberflächenschicht auf der Basis von Chromkarbid enthaltendem Chromoxid einen in Chromhexacarbonyl bestehenden Vorläufer wählt, den besagten Vorläufer auf eine Temperatur zwischen etwa 10°C und 40°C bringt, um einen Teil davon in die Dampfphase zu versetzen, den gewonnenen Dampf mit Hilfe eines in Sauerstoff bestehenden Trägergases befördert, das Substrat auf eine Temperatur zwischen 260°C und 320°C bringt und das Trägergas und den Dampf mit dem besagten Substrat in Kontakt bringt.

10. Anwendung des Verfahrens nach einem der Ansprüche 1 bis 9 zur Herstellung eines Schutzfilmes auf einem Substrat aus einer Magnesiumlegierung der folgenden Gruppe: GA9 (Mg, 9% Al), GA9Z1 (Mg, 9% Al, 1% Zn), MSR (Mg, 2% seltene Erden, 2% Ag, 0.5% Zr), RZ5 (Mg, 4% Zn, 1% seltene Erden, 0.5% Zr).

11. Anwendung nach Anspruch 10, bei der man das beschichtete Substrat in einer kochenden wäßrigen Lösung einer Abdichtbehandlung unterzieht.
